# EUROPÄISCHE PATENTANMELDUNG

(11) **EP 1 953 890 A2**
(43) Veröffentlichungstag der Anmeldung: **06.08.2008**
(21) Anmeldenummer: 08150082.9
(22) Anmeldetag: 08.01.2008
(51) Int. Cl.: H02H 9/08, G01R 31/02, H02H 3/00

(54) **Vorrichtung und ein Verfahren zur Injektion eines Hilfssignals in das Nullsystem eines elektrischen Verteilernetzes**

(30) Priorität: 01.02.2007 AT 1652007
(71) Anmelder: Adaptive Regelsysteme Gesellschaft mbH, 5020 Salzburg (AT)
(72) Erfinder: Leikermoser, Albert, 5020 Salzburg (AT)
(74) Vertreter: Weiss, Christian

(57) **Zusammenfassung**

Zur Bestimmung von Netzparametern, zur Abstimmung einer Löschspule oder zur Erkennung von Erdfehlern in elektrischen Verteilnetzen wird häufig ein Hilfssignal in das Nullsystem des Verteilnetzes eingespeist, um bestimmte Nullsystemgrößen, wie z.B. die Nullspannung oder den Nullstrom, zu ändern und damit eine Auswertung zu ermöglichen. Um solche Hilfssignale einzuspeisen war bisher eine eigene Hilfsstromquelle oder Hilfsspannungsquelle erforderlich, die den Aufwand für eine solche Einspeisung erhöht. Die gegenständliche Erfindung beschreibt nun eine Vorrichtung und ein Verfahren zum Einspeisen eines Hilfssignals in das Nullsystem eines elektrischen Verteilnetzes ohne externe Energieversorgung. Dazu wird erfindungsgemäß vorgeschlagen, eine Injektionseinrichtung 5 zwischen einen Phasenleiter 2 und Erde zu schalten, womit die Injektionseinrichtung 5 von einer Phasenspannung versorgt wird.

## Beschreibung

Die gegenständliche Erfindung betrifft eine Vorrichtung und ein Verfahren zur Injektion eines Hilfssignals in das Nullsystem eines elektrischen Verteilnetzes mit einer Anzahl elektrischer Phasenleiter.

Zur Reduktion der Fehlerströme beim Auftreten von Erdfehlern in elektrischen Verteilnetzen wird der Sternpunkt des Speisetransformators oder eines Sternpunktbildners vorzugsweise induktiv geerdet, das Netz also sternpunktkompensiert betrieben. Die Induktivität dieser, zwischen dem Sternpunkt des Speisetransformators und dem Erdpotential angeordneten, Erdschlusslöschspule ist bekannterweise den unterschiedlichen Netzkonfigurationen jeweils nach einer Änderung der Netztopologie neu anzupassen (abzustimmen). Verfahren zur Bestimmung von Netzparametern des Nullsystems eines elektrischen Netzes oder eines Abzweiges davon, zur Bestimmung eines fehlerhaften Leitungsabschnitts oder -abzweigs oder zur Abstimmung von Erdschlusslöschspulen verwenden oftmals Hilfssignale, die in das Nullsystem des elektrischen Netzes injiziert werden.

Im Nullsystem wird mit Nullsystemgrößen, wie dem Nullstrom oder die Nullspannung, das Verhalten elektrischer Netze gegen Erde (bzw. gegen ein Bezugspotential) beschrieben. Der Zweck der Injektion von Signalen ins Nullsystem des Netzes ist eine, durch die Signalinjektion bewirkte, Änderung von zumindest einer der Nullsystemgrößen, beispielsweise Nullspannung und/oder Nullstrom.

In der EP 595 677 A1 wird z.B. ein Verfahren zur Messung von Abstimmung und Verstimmung der Kompensation eines elektrischen Versorgungsnetzes vorgestellt, bei dem man in das Nullsystem des Netzes ein Injektionssignal (Messhilfssignal) einbringt, die durch das Injektionssignal verursachte Nullspannungsänderung ermittelt und die Nullimpedanz des Netzes aus der Nullspannungsänderung und dem gemessenen Injektionsstrom in Betrag und Phase ermittelt. Die Einbringung dieses Injektionssignales ins Nullsystem des Netzes erfolgt entweder durch eine Spannungsquelle, die mit der Erdschlusslöschspule in Reihe geschaltet wird, oder durch eine Vorrichtung, die durch eine, zur Erdschlusslöschspule parallele Stromquelle, repräsentiert werden kann. In beiden Fällen wird eine aktive Spannungsquelle zur Erzeugung des Injektionssignales benützt.

Gemäß dem Verfahren nach der WO 02/15355 A1 wird ein, aus einem netzfrequenten und zumindest einem nicht netzfrequenten Anteil bestehendes, Hilfssignal so in das Nullsystem des Netzes eingespeist, dass dessen netzfrequenter Anteil die Nullspannung des Netzes zwecks Ortung hochohmiger Erdfehler kompensiert und ein überlagerter nicht netzfrequenter Anteil einerseits zur Bestimmung von Nullsystemparametern von Leitungsabzweigen und/oder vom Gesamtnetz als auch zur Abstimmung der Erdschlusslöschspule benützt werden kann. Gemäß der WO 2004/003578 A1 wird ein, aus zumindest einem nicht netzfrequenten Anteil bestehendes, Hilfssignal zwecks Bestimmung von Nullsystemparametern von Leitungsabzweigen und/oder vom Gesamtnetz in das Nullsystem des Netzes eingespeist. Die ermittelten Parameter können dann wiederum einerseits im Zusammenhang mit Fehlerortungsalgorithmen als auch zur Abstimmung der Erdschlusslöschspule verwendet werden. In der EP 1 693 679 A1 wird ein impulsartiges Signal zur Bestimmung von Nullsystemparametern von Leitungsabzweigen und/oder vom Gesamtnetz in das Nullsystem des Netzes eingespeist. Die ermittelten Parameter können dann wiederum einerseits im Zusammenhang mit Fehlerortungsalgorithmen als auch zur Abstimmung der Erdschlusslöschspule verwendet werden.

Auch die drei letztgenannten Verfahren benötigen zur Erzeugung der Injektionssignale Spannungs- oder Stromquellen, die von einer bereitzustellenden Hilfsenergieversorgung versorgt werden müssen. Dies bedeutet aber auch, dass zur Bereitstellung dieser Spannungs- oder Stromquelle anlagenseitig eine Hilfsenergieversorgung vorhanden sein muss, an die einerseits sehr hohe Anforderungen bezüglich Ausfallsicherheit zu stellen ist und die andererseits nicht unerhebliche Kosten verursacht.

Eine Aufgabe der gegenständlichen Erfindung ist es daher, die durch eine anlagenseitige Hilfsenergieversorgung zur Injektionssignalerzeugung verursachten Nachteile zu eliminieren.

Diese Aufgabe wird für die Vorrichtung und das Verfahren erfindungsgemäß dadurch gelöst, indem im Nullsystem des elektrischen Verteilnetzes eine Injektionseinrichtung vorgesehen ist, die zumindest einen ausgezeichneten ersten und zweiten elektrischen Anschluss aufweist, wobei der erste ausgezeichnete Anschluss mit einem der elektrischen Phasenleiter des Netzes und der zweite ausgezeichnete Anschluss mit der Erde verbunden ist. Auf eine Hilfsenergieversorgung zur Injektionssignalerzeugung kann dabei gänzlich verzichtet werden, da die dazu notwendige Energie direkt dem elektrischen Verteilnetz entnommen wird. Da der eine der beiden ausgezeichneten elektrischen Anschlüsse der Injektionseinrichtung mit einem der Phasenleiter des Netzes und der andere mit Erde verbunden ist, steht somit als Differenzspannung zwischen den beiden ausgezeichneten Anschlüssen eine der Phasen-Erdspannungen des Netzes an. Dies bedeutet, dass im erdfehlerfreien Netzzustand zwischen den beiden ausgezeichneten Anschlüssen der Injektionseinrichtung eine Spannung auftritt, die ungefähr der Phasenspannung des Netzes entspricht, da die Nullspannung (Sternpunkt-Erdspannung) aufgrund der Erdfehlerfreiheit des Netzes sehr klein sein wird. Andererseits wird im Erdfehlerfall über diese beiden Anschlüsse ohne Berücksichtigung von transienten Überspannungen maximal die größte der verketteten Spannungen, also die größte der einzelnen Differenzspannungen zwischen den Phasen, des Netzes auftreten.

Aufgrund dieser Tatsache ergibt sich gegenüber bisher üblichen Injektionsmethoden ein weiterer Vorteil des dargelegten Injektionsprinzips. Dieser Vorteil ist in der Tatsache begründet, dass sich im Erdschlussfall die über die beiden ausgezeichneten Anschlüsse der Injektionseinrichtung anstehende Spannung gegenüber dem erdfehlerfreien Netzzustand ohne Berücksichtigung von transienten Überspannungen in Dreiphasennetzen nur maximal um den Faktor 1,73, eben dem Verhältnis von verketteter Spannung zu Phasenspannung, erhöht. Dies stellt bei üblicher Auslegung hinsichtlich der Überspannungs- und Überstromsicherheit der Injektionseinrichtung kein konstruktives Problem dar. Bei üblichen Injektionsmethoden verursacht gerade der Überstrom- und Überspannungsschutz im Zusammenhang mit dem Auftreten von Erdfehlern während des Injektionsvorganges erhebliche Kosten und Aufwendungen.

Die Injektionseinrichtung kann dabei erfindungsgemäß als beliebiges Zweipol- oder Mehrpolschaltungsnetzwerk mit zumindest zwei ausgezeichneten Anschlüssen ausgeführt werden, wodurch die konkrete Realisierung sehr flexibel ist.

Wenn die Impedanz bzw. Admittanz des Zweipol- oder Mehrpolschaltungsnetzwerks bezüglich dieser beiden ausgezeichneten Anschlüsse über eine Steuereinrichtung kontinuierlich oder in Stufen veränderbar ist, kann das injizierte Hilfssignal (in Form, Leistungsinhalt oder Frequenzspektrum) sehr einfach geändert werden.

Ganz besonders einfach kann die Injektionseinrichtung mithilfe eines durch seine Impedanz bzw. Admittanz repräsentierten elektrischen Zweipoles realisiert werden, der über eine Steuereinrichtung, bevorzugt eine Schalteinrichtung, zwischen einem der Phasenleiter des Netzes und Erde zu- oder weggeschaltet wird. Ein solcher Zweipol kann durch elementare elektrische Bauelemente, wie ohmsche Widerstände R, Induktivitäten L oder Kondensatoren C oder jeder beliebigen Kombination dieser Komponenten, aufgebaut werden und ist daher einfach und kostengünstig.

Ebenso einfach und vorteilhaft kann die Injektionseinrichtung mithilfe eines Transformators oder eines sehr oft in der Anlage bereits verfügbaren Spannungswandlers gebildet werden, dessen Primärseite mit den ausgezeichneten Anschlüssen verbunden ist und wobei es vorteilhaft ist, die Sekundärseite des Transformators mit der aus einer Steuereinrichtung, bevorzugt eine Schalteinrichtung, in Serie mit einem Zweipol bestehenden Serienschaltung zu verbinden. Durch die Steuereinrichtung kann das Injektionssignal zu- und weggeschaltet werden. Durch Anordnen der Steuereinrichtung auf der Niederspannungsseite des Transformators kann diese auch durch günstige elektronische Bauelemente realisiert werden. Zusätzlich wird vorteilhaft auf der Sekundärseite des Transformators ein durch seine Impedanz bzw. Admittanz repräsentierter elektrischer Zweipol in Serie zur Steuereinrichtung geschaltet, wodurch die Admittanz bzw. Impedanz des Zweipoles flexibel und einfach festgelegt werden kann. Dieser Zweipol kann ebenfalls aus einem Bauelement oder aus einem Netzwerk von beliebig seriell oder parallel zusammengeschalteten elektrischen Bauteilen wie ohmschen Widerständen R, Induktivitäten L und/ oder Kondensatoren C bestehen.

Das Injektionssignal kann ebenfalls einfach zu- und weggeschaltet werden, indem in der Injektionseinrichtung eine Steuereinrichtung, bevorzugt eine Schalteinrichtung, vorgesehen ist, die als Serienschaltung mit dem elektrischen Zweipol- oder Mehrpolschaltungsnetzwerk zwischen dem gewählten elektrischen Phasenleiter und Erde geschaltet ist.

Komplexere Hilfssignale (in Form, Leistungsinhalt oder Frequenzspektrum) lassen sich einfach erzeugen, wenn im elektrischen Verteilnetz mehrere erfindungsgemäße Injektionseinrichtungen vorgesehen sind, die jeweils mit einer der elektrischen Phasen und mit Erde verbunden sind und die gleichzeitig oder sequentiell betrieben werden.

Durch eine phasensynchronisierte Ansteuerung der Injektionseinheit mittels einer Synchronisationseinrichtung kann eine hohe Reproduzierbarkeit des Injektionsvorganges gewährleistet werden und können weiters bezüglich der elektrischen Komponenten günstige Anschalt- und Abschaltzeitpunkte innerhalb der Netzperiode ausgewählt werden.

Durch eine übergeordnete Steuereinheit kann der Zeitpunkt und die Dauer der Injektion, sowie auch Form und Leistung des zu injizierenden Hilfssignals einfach gesteuert werden.

Die vorliegende Erfindung wird anhand der schematischen, nicht einschränkenden, bestimmte Ausführungsbeispiele zeigenden Figuren 1 bis 4 beschrieben, wobei
Fig. 1 ein Ersatzschaltbild eines vereinfachten Modells eines dreiphasigen sternpunktkompensierten elektrischen Verteilnetzes,
Fig. 2 und 3 jeweils ein Ersatzschaltbild mit einer erfindungsgemäßen Injektionseinrichtung und
Fig. 4 eine Phasensynchronisation der Injektionseinrichtung zeigt.

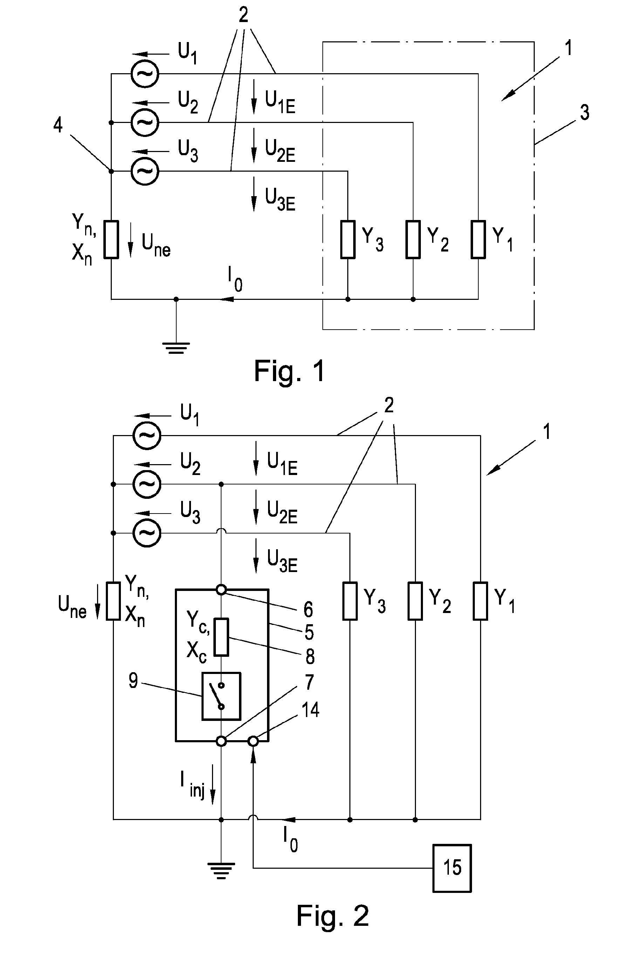

Die Fig. 1 zeigt ein Ersatzschaltbild eines vereinfachten Modells eines dreiphasigen sternpunktkompensierten elektrischen Verteilnetzes 1 mit drei Phasenleitern 2, das hier aus einem Leitungsabschnitt 3 besteht. Selbstverständlich könnten aber auch, wie in der Realität üblich, mehrere Leitungsabschnitte 3 oder Leitungsabzweige vorhanden sein oder das Verteilnetz 1 nicht sternpunktkompensiert sein. Da die Lastströme im Nullsystem weitgehend ohne Einfluss sind, ist das Verteilnetz 1 hier ohne Verbraucher dargestellt. Da es bei der Erfindung aber nur auf das Nullsystem ankommt, hat die genaue Topologie des elektrischen Verteilnetzes 1 keine Bedeutung. Der Speisetransformator liefert die Phasenspannungen U₁, U₂, U₃ und zwischen den Phasen und Erde bilden sich die Phasen-Erdspannungen U_{1E}, U_{2E}, U_{3E}. Zwischen Sternpunkt 4 und Erde befindet sich die Sternpunkt-Erdadmittanz Yₙ, bzw. die Sternpunkt-Erdimpedanz Xₙ, die, wie bekannt, der Kehrwert der Sternpunkt-Erdadmittanz Yₙ ist, an der die Nullspannung (Sternpunkt-Erdspannung) Uₙₑ anliegt. Die Summe der Nullströme der einzelnen Leitungsabschnitte oder Leitungsabzweige des Netzes fließt als Nullstrom Iₒ über den Sternpunkt 4 zum Speisetransformator zurück.

Die sogenannte Nullspannung ergibt sich dabei aus der Summe der einzelnen Phasen-Erdspannungen U_{1E}, U_{2E}, U_{3E} und ist unter der Voraussetzung, dass die Summe der einzelnen Phasenspannungen U₁, U₂ und U₃ des Netzes Null ergibt, identisch mit der Sternpunkt-Erdspannung Uₙₑ. Der sogenannte Nullstrom I₀ entspricht dem im Erdreich fließenden Strom und wird aus den einzelnen Phasenströmen durch Summenbildung berechnet.

Bei diesem Modell bleiben weiters die Leitungslängsimpedanzen, die Streuimpedanzen des Speisetransformators, die von den Nullströmen durchflossenen Erdimpedanzen und die Leitungskoppelkapazitäten zwischen den einzelnen Phasen aus Gründen der Übersichtlichkeit und ihres geringen Einflusses im Nullsystem unberücksichtigt. Sie könnten jedoch ohne Beeinträchtigung der gegenständlichen Erfindung mitberücksichtigt werden. Dies würde lediglich zu einer Erhöhung der Ordnung der Modellgleichungen führen.

Es ist auch leicht zu zeigen, dass sich die Phasen-Erdadmittanzen einzelner Leitungsabschnitte 3 des Gesamtnetzes 1 im Frequenzbereich bis ca. 150 Hz in guter Näherung durch die Parallelschaltung einer Abschnittskapazität mit einem Abschnittsableitwiderstand beschreiben lassen. Die drei Phasen-Erdadmittanzen Y₁, Y₂, Y₃ des Gesamtnetzes 1 ergeben sich aufgrund der Nichtberücksichtigung der Leitungslängsimpedanzen durch Parallelschaltung der Phasen-Erdadmittanzen der einzelnen Leitungsabschnitte 3 und somit durch phasenbezogene Summation der Leitungsabschnittsadmittanzen über alle Leitungsabzweige oder -abschnitte 3 des Gesamtnetzes 1.

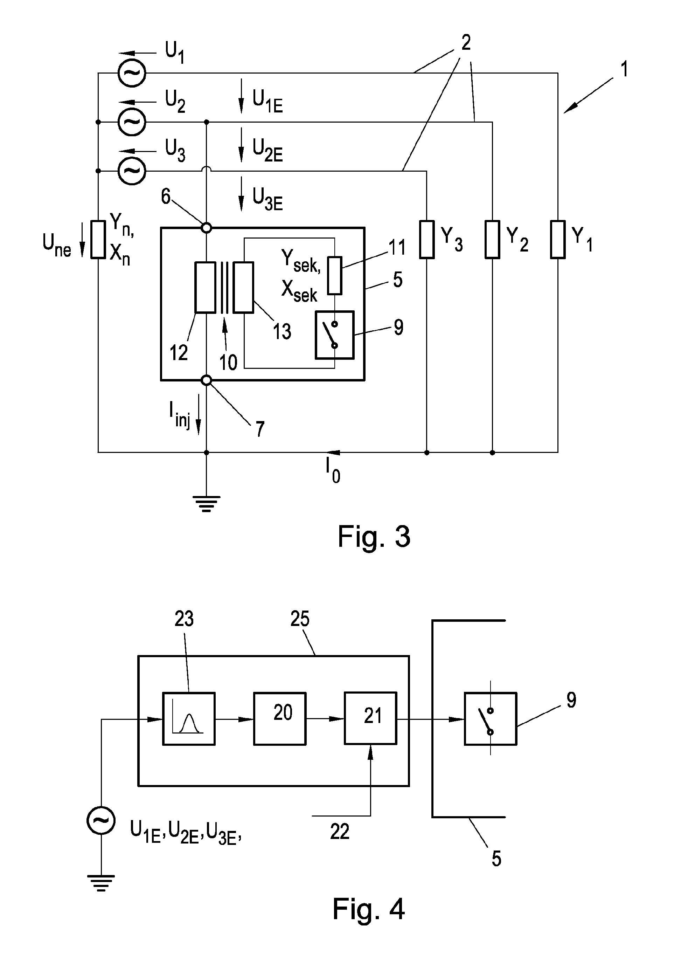

Um nun ein Hilfssignal, wie z.B. einen Injektionsstrom Iᵢₙⱼ, in das Nullsystem des elektrischen Netzes 1 zu injizieren ist eine Injektionseinrichtung 5 vorgesehen, die einen ersten ausgezeichneten Anschluss 6 und einen zweiten ausgezeichneten Anschluss 7 aufweist, wie in den Figs. 2 und 3 dargestellt. Der erste Anschluss 6 ist hier beispielsweise mit der zweiten Phase des elektrischen Netzes 1 verbunden und der zweite Anschluss 7 mit Erde. Somit wird die Injektionseinrichtung 5 direkt an die Phase 2 mit der Phasen-Erdspannung U_{2E} angeschaltet und die Injektionseinrichtung 5 somit über die zweite Phase mit elektrischer Energie versorgt, eine zusätzliche Hilfsversorgung in Form einer externen Strom- oder Spannungsquelle kann daher entfallen. Die Phasen-Erdspannungen U_{1E}, U_{2E}, U_{3E} sind üblicherweise an den Sammelschienen oder im Netz 1 verfügbar und können somit einfach abgegriffen werden.

In einer ersten Ausführungsvariante gemäß Fig. 2 wird als Injektionseinrichtung 5 ein durch die Admittanz Y_{c} bzw. Impedanz X_{c} repräsentierter elektrischer Zweipol 8 mithilfe einer zu diesem Zweipol 8 in Serie geschalteten Schalteinrichtung 9 zwischen der (hier beispielhaft gewählten) zweiten Phase mit der Phasen-Erdspannung U_{2E} und Erde direkt angeschaltet. Für die Erfindung ist es aber unerheblich, welche der verfügbaren Phasen für die Anschaltung benützt wird. Zur Injektion wird die Schalteinrichtung 9 geschaltet, also je nach Ausführung geöffnet oder geschlossen. Für eine permanente Injektion eines Hilfssignals, z.B. eines Injektionsstromes Iᵢₙⱼ, kann die Schalteinrichtung 9 auch entfallen.

Diese direkte Anschaltung des Zweipols 8 der Injektionseinrichtung 5 bedingt, dass die Schalteinrichtung 9 sehr hohen Spannungsbeanspruchungen ausgesetzt sein kann. Dies kann den Einsatz von elektronischen Schaltelementen verhindern und die Anwendung von mechanischen Schaltelementen, wie z.B. elektrische Mittelspannungsschalter notwendig machen, was letztendlich die Kosten erhöht.

In einer zweiten Ausgestaltung einer Injektionseinrichtung 5 wird ein Zweipol 11 über einen Einphasentransformator 10 an eine frei wählbare Phase mit der zugehörigen Phasen-Erdspannung U_{1E}, U_{2E} oder U_{3E} geschaltet. Bei dieser, auch als transformatorische Ankopplung bzw. Anschaltung bezeichnete, Ausführungsvariante wird entsprechend Fig. 3 die Hochspannungswicklung (Primärseite) 12 eines geeigneten Einphasentransformators 10 oder Spannungswandlers über den ersten Anschluss 6 einerseits mit der Phasen-Erdspannung U_{2E} der (hier beispielhaft gewählten) zweiten Phase und über den Anschluss 7 andererseits mit Erde verbunden. Damit wird die Injektionseinrichtung 5 wiederum über eine Phase mit elektrischer Energie versorgt. An der Sekundärseite 13 dieses Einphasentransformators 10 wird ein durch dessen Admittanz Yₛₑₖ bzw. Impedanz Xₛₑₖ repräsentierter Zweipol 11 in Serie mit einer Schalteinrichtung 9 angeschaltet. Die Schalteinrichtung 9 kann aufgrund des niedrigeren Spannungsniveaus auf der Sekundärseite 13 des Einphasentransformators 10 elektronisch oder elektromechanisch ausgeführt sein. Es ist aber grundsätzlich auch denkbar, die Schalteinrichtung 9 auf der Primärseite 12 vorzusehen. Für die Erfindung ist es auch unerheblich, welche der verfügbaren Phasen für die Anschaltung benützt wird. Zur Injektion eines Hilfssignals, z.B. eines Injektionsstromes lᵢₙⱼ, kann diese Schalteinrichtung 9 nun den Zweipol 11 an die Sekundärseite 13 des Transformators 10 anschalten. Für eine permanente Injektion eines Hilfssignals, z.B. eines Injektionsstromes lᵢₙⱼ, kann die Schalteinrichtung 9 auch entfallen.

Der Fachmann erkennt sofort die elektrotechnische Äquivalenz der beiden Ausführungsvarianten nach Fig. 2 und Fig. 3, da dieser Einphasentransformator 10 im wesentlichen nur zur galvanischen Trennung und zur Anpassung der Spannungs- und Strompegel für die Schalteinrichtung 9 auf applikationsspezifisch gewünschte Niveaus benötigt wird. Durch diese Reduktion der Spannungsbeanspruchung können für die Schalteinrichtung 9 sehr schnelle und preiswerte elektronische Schalter zur Anwendung kommen.

Im Falle des Einsatzes von unipolaren elektronischen Schaltern, wie z.B. bipolare Transistoren, IGBT's, Thyristoren oder FET's, ist vorzugsweise eine geeignete Gleichrichterschaltung vorzusehen oder es werden beispielsweise zwei unipolare elektronische Schalter mit jeweils einer Längsdiode parallel zu einem Array verschaltet. Werden bipolare elektronische Schaltelemente, wie z.B. TRIAC's oder elektromechanische Schalter, eingesetzt, so entfallen natürlich die oben erwähnten Dioden.

Im Falle einer fixen Anschaltung des Einphasentransformators 10 an eine der drei Phasen-Erdspannungen U_{1E}, U_{2E}, U_{3E} fließt kontinuierlich der Magnetisierungsstrom dieses Transformators 10. Da dieser Magnetisierungsstrom aber im Vergleich zu dem primären Laststromanteil, der durch die Anschaltung des Zweipoles 11 mithilfe der Schalteinrichtung 9 an die Sekundärseite 13 des Transformators 10 verursacht wird, klein ist, kann man in guter Näherung diesen Magnetisierungsstrom zur Vereinfachung auch vernachlässigen. Es könnte aber natürlich auch auf der Primärseite 12 eine zusätzliche Schalteinrichtung vorgesehen werden, die die Injektionseinrichtung 5 von der Phase trennt.

Bei Vernachlässigung des Magnetisierungsstromes setzt sich der resultierende, auf die Primärseite 12 bezogene, Zweipol aufgrund des hinreichend bekannten elementaren Transformatorersatzschaltbildes aus einer Serienschaltung von der primären und sekundären Streuinduktivität des Transformators 10 in Serie mit dem primären und sekundären ohmschen Wicklungswiderstand (Kupferwiderstand) des Transformators 10 in Serie mit dem sekundär über die Schalteinrichtung 9 angeschalteten Zweipolimpedanz 11 zusammen, wobei die elektrischen Parameter der sekundären Elemente in bekannter Weise mit dem Quadrat des Transformatorübersetzungsverhältnisses auf die Primärseite 12 umzurechnen sind.

Die Impedanzen Xₛₑₖ und X_{c}, bzw. die Admittanzen Yₛₑₖ und Y_{c}, der Zweipole 8, 11 können durch beliebige Schaltungsanordnungen elektrischer Bauelemente gebildet werden, z.B. eine beliebige serielle oder parallele Schaltungskombination aus einem oder mehreren ohmschen Widerständen R, einer oder mehrerer Induktivitäten L und/oder einem oder mehreren Kondensatoren C, je nach Anwendungsfall. Wird z.B. ein diracähnlicher Injektionsstromimpuls angestrebt, so wird der genannte Zweipol 8, 11 beispielsweise durch einen Widerstand R oder durch die Serienschaltung von einem Widerstand R mit einem Kondensator C realisiert. Wird eine Einspeisung von vorwiegend netzfrequenten Signalen angestrebt, so ist aus Verlustleistungsgründen die Verwendung eines bipolaren Kondensators C oder einer Drosselspule mit Induktivität L gegenüber einem ohm'schen Widerstand R zur Realisierung des Zweipoles 8, 11 vorteilhaft.

Die einzelnen Komponenten des Zweipols 8, 11 können natürlich auch automatisch verstellbar sein, z.B. über entsprechende Steuerbefehle der übergeordneten Steuereinrichtung 15, sodass die Impedanzen Xₛₑₖ und X_{c}, bzw. die Admittanzen Yₛₑₖ und Y_{c}, und damit auch das zu injizierende Hilfssignal, auch bedarfsgemäß eingestellt werden können.

Grundsätzlich ist es aber auch denkbar, die Injektionseinrichtung 5 nicht zwingend als Serienschaltung eines Zweipoles 8, 11 mit einer Schalteinrichtung 9, sondern als beliebiges Zweipol- oder Mehrpolschaltungsnetzwerk mit zwei ausgezeichneten elektrischen Anschlüssen auszuführen, dessen erster ausgezeichneter Anschluss in zu oben analoger Weise einerseits mit einem der Phasenleiter des Netzes (mit dessen zugehöriger Phasen-Erdspannung) und dessen zweiter ausgezeichneter Anschluss mit Erde verbunden wird. Die Impedanz bzw. Admittanz der Zweipol- oder Mehrpolschaltung bezüglich der beiden ausgezeichneten Anschlüsse (Zweipolimpedanz) kann zusätzlich über eine Steuereinrichtung kontinuierlich oder in Stufen veränderbar (also auch zu- oder weggeschaltet werden kann) sein. In der einfachsten Ausführungsvariante wird diese Steuereinrichtung durch eine elektrische oder elektronische Schalteinrichtung realisiert, die die Laplace- oder Fourier-Transformierte der Impedanz (Admittanz) dieser Zwei- oder Mehrpolschaltung bezüglich dieser zwei Anschlüsse abhängig von der Schalterstellung zwei unterschiedliche Zustände annehmen lässt. Natürlich ist aber auch eine Variante einer Steuereinrichtung denkbar, die es gestattet, die Impedanz (Admittanz) des Zwei- oder Mehrpolnetzwerkes bezüglich der beiden ausgezeichneten Anschlüsse stufenlos zu verändern, wie dies zum Beispiel mit getakteten elektronischen Stelleinrichtungen möglich ist.

Ferner sei der Vollständigkeit halber auch erwähnt, dass das erfindungsgemäße Prinzip der Anschaltung von Injektionseinrichtungen 5 zur Injektion von Hilfssignalen in das Nullsystem des elektrischen Verteilnetzes 1, z.B. zwecks Erzeugung von Nullspannungsänderungen, bezüglich der Anzahl der verwendeten Injektionseinrichtungen 5 nicht begrenzt ist. Natürlich können bei Bedarf auch mehrere Injektionseinrichtungen 5 in beliebiger Ausführung, z.B. mit direkt oder transformatorisch angeschaltetem Zweipol 8, 11, an die unterschiedlichen Phasen-Erdspannungen U_{1E}, U_{2E}, U_{3E} zeitlich gleichzeitig oder sequentiell angeschaltet werden. Die Verwendung mehrerer Injektionseinrichtungen 5, beispielsweise auch an der gleichen Phase, könnte z.B. für die Erzeugung besonderer Hilfssignale, wie z.B. spezieller Impulsmuster, vorgesehen werden.

Wie in Fig. 2 angedeutet kann auch eine übergeordnete Steuereinrichtung 15 vorgesehen sein, die Zeitpunkt und Dauer der Injektion, sowie unter Umständen auch Form und Leistung des zu injizierenden Hilfssignals, wie z.B. ein pulsförmiges Injektionssignal oder ein bestimmtes Pulsmuster oder ein Injektionssignal bestimmter Spannung und Phase, vorgibt, z.B. indem die Steuereinrichtung 9 entsprechend angesteuert wird. Dazu kann die Injektionseinrichtung 5 auch einen eigenen externen Steuereingang 14 besitzen, an dem die Steuereinrichtung 15 angeschaltet werden kann. Weiters können in der Injektionseinrichtung 5 auch entsprechende Einrichtungen, wie z.B. ein Mikroprozessor oder eine logische Schaltung zur Verarbeitung der Steuersignale vorgesehen sein.

Speziell, aber nicht ausschließlich, im Falle der Injektion eines Impulses oder einer Sequenz von impulsartigen Signalen, könnten diese bezüglich ihrer Phase mittels einer Synchronisationseinrichtung 25 auch mit der zur Injektion benützten Phasen-Erdspannung U_{1E}, U_{2E}, U_{3E} synchronisiert werden. Durch eine derartige Synchronisation ist die Reproduzierbarkeit des Injektionsvorganges in einem hohen Maße gewährleistet. Ferner können, abhängig von der verwendeten Injektionseinrichtung 5, bezüglich der elektrischen Eigenschaften der Komponenten günstig gewählte Anschalt- und Abschaltzeitpunkte innerhalb der Netzperiode ausgewählt werden.

Eine solche Synchronisationseinrichtung 25 könnte, z.B. wie in Fig. 4 gezeigt, einen Bandpassfilter 23, eine PLL (phase locked loop) Schaltung 20 und eine Ansteuerlogik 21 aufweisen. Ein bandpassgefiltertes Messsignal von der zur Injektion benützten Phasen-Erdspannung U_{1E}, U_{2E} oder U_{3E} wird dabei der PLL-Schaltung 20 zugeführt, die ein phasensynchronisiertes Steuersignal an die Ansteuerlogik 21 weitergibt. Die Schalteinrichtung 9 kann nun phasensynchronisiert über die Ansteuerlogik 21, die z.B. von einer Injektionsanforderung 22 aktiviert wird, angesteuert werden. Der Vollständigkeit halber ist zu erwähnen, dass diese Phasensynchronisation des Injektionssignales natürlich auch ohne Einschränkung des Prinzips mit jedem anderen periodischen netzfrequenten Signal, dessen Oberwellenanteile unter Umständen mit einem auf die Netzfrequenz abgestimmten Bandpassfilter herausgefiltert werden, hergestellt werden kann. Die Synchronisationseinrichtung 25 kann natürlich auch in der Injektionseinrichtung 5 integriert sein. In diesem Fall könnte die Injektionsanforderung 22 z.B. auch über einen externen Steuereingang 14 der Injektionseinrichtung 5 durch die übergeordnete Steuerung 15 zugeführt werden.

Ebenso ist es möglich, das Prinzip der dargelegten Injektion eines Hilfssignals bezüglich des zeitlichen Verhaltens auch zu invertieren, sodass im stationären Zustand ein Hilfssignal injiziert wird, z.B. indem der Zweipol 8, 11 über die Schalteinrichtung 9 im stationären Ausgangszustand angeschaltet ist, und die Injektion, z.B. zwecks Nullspannungsänderung, durch Unterbrechen der Injektion, z.B. durch Wegschalten des Zweipols 8, 11 mittels der Schalteinrichtung 9, definiert ist. Diese Betriebsart kann durch einfache logische Inversion des Steuersignals für die Injektionseinrichtung 5 erreicht werden und kann deshalb als Inversbetrieb bezeichnet werden.

Es sei abschließend noch erwähnt, dass sich die für die Ansteuerung der Schalteinrichtung 9 notwendige Hilfsenergie aufgrund ihrer geringen Leistungsanforderungen in einfacher Weise aus der an der Schalteinrichtung 9 anstehenden Spannung oder aus dem für eine Phasensynchronisation benützten Spannungssignal gewonnen werden kann.

## Patentansprüche

1. Vorrichtung zur Injektion eines Hilfssignals in das Nullsystem eines elektrischen Verteilnetzes (1) mit einer Anzahl elektrischer Phasenleiter (2), **dadurch gekennzeichnet, dass** eine Injektionseinrichtung (5) vorgesehen ist, die zumindest einen ersten und einen zweiten elektrischen Anschluss (6, 7) aufweist, wobei der erste Anschluss (6) der Injektionseinrichtung (5) mit einem beliebigen Phasenleiter (2) des Verteilnetzes (1) und der zweite Anschluss (7) mit der Erde verbunden ist.

2. Vorrichtung nach Anspruch 1, **dadurch gekennzeichnet, dass** die Injektionseinrichtung (5) als Zweipol- oder Mehrpolschaltungsnetzwerk mit zumindest zwei ausgezeichneten Anschlüssen (6, 7) ausgeführt ist.

3. Vorrichtung nach Anspruch 2, **dadurch gekennzeichnet, dass** die Impedanz bzw. Admittanz des Zweipol- oder Mehrpolschaltungsnetzwerks bezüglich der beiden Anschlüsse (6, 7) über eine Steuereinrichtung kontinuierlich oder in Stufen veränderbar ist.

4. Vorrichtung nach einem der Ansprüche 1 bis 3, **dadurch gekennzeichnet, dass** als Injektionseinrichtung (5) ein durch seine Impedanz (X_{c}) bzw. Admittanz (Y_{c}) repräsentierter elektrischer Zweipol (8) in Serie mit einer Steuereinrichtung vorgesehen ist.

5. Vorrichtung nach einem der Ansprüche 1 bis 3, **dadurch gekennzeichnet, dass** als Injektionseinrichtung (5) ein Transformator (10) oder ein Spannungswandler vorgesehen ist, dessen Primärwicklung (12) mit den Anschlüssen (6, 7) verbunden ist und dessen Sekundärseite (13) mit der Serienschaltung eines, durch seine Impedanz (Xₛₑₖ) bzw. Admittanz (Yₛₑₖ) repräsentierten, elektrischen Zweipoles (11) mit einer Steuereinrichtung verbunden ist.

6. Vorrichtung nach einem der Ansprüche 2 bis 5, **dadurch gekennzeichnet, dass** in der Injektionseinrichtung (5) eine Steuereinrichtung vorgesehen ist, die in Serie zum Zweipol- oder Mehrpolschaltungsnetzwerk zusammen als Serienschaltung zwischen dem elektrischen Phasenleiter (2) und Erde angeordnet ist.

7. Vorrichtung nach einem der Ansprüche 3 bis 6, **dadurch gekennzeichnet, dass** die Steuereinrichtung als Schalteinrichtung (9) ausgeführt ist.

8. Vorrichtung nach einem der Ansprüche 1 bis 7, **dadurch gekennzeichnet, dass** im elektrischen Verteilnetz (1) mehrere Injektionseinrichtungen (5) vorgesehen sind, die jeweils mit einem der Phasenleiter (2) des Verteilnetzes (1) und mit Erde verbunden sind.

9. Vorrichtung nach einem der Ansprüche 1 bis 8, **dadurch gekennzeichnet, dass** zur phasensynchronisierten Ansteuerung der Injektionseinrichtung (5) eine Synchronisationseinrichtung (25) vorgesehen ist.

10. Vorrichtung nach einem der Ansprüche 1 bis 9, **dadurch gekennzeichnet, dass** eine übergeordnete Steuereinheit (15) vorgesehen ist, mittels der die Injektionseinrichtung (5) ansteuerbar ist.

11. Verfahren zur Injektion eines Hilfssignals in das Nullsystem eines elektrischen Verteilnetzes (1) mit einer Anzahl elektrischer Phasenleiter (2), **dadurch gekennzeichnet, dass** das Hilfssignal durch eine zwischen einem der elektrischen Phasenleiter (2) und Erde geschaltete Injektionseinrichtung (5) erzeugt und in das Nullsystem eingespeist wird.

12. Verfahren nach Anspruch 11, **dadurch gekennzeichnet, dass** das Hilfssignal zu einem netzfrequenten Signal phasensynchronisiert wird.

13. Verfahren nach Anspruch 11 oder 12, **dadurch gekennzeichnet, dass** die Injektionseinrichtung (5) zur Erzeugung eines vorgegebenen Hilfssignals von einer übergeordneten Steuereinheit (15) angesteuert wird.

14. Verfahren nach einem der Ansprüche 11 bis 13, **dadurch gekennzeichnet, dass** mehrere Injektionseinrichtungen (5) gleichzeitig oder sequentiell betrieben werden.
